# EUROPEAN PATENT APPLICATION

(11) **EP 4 394 396 A1**
(43) Date of publication of application: **03.07.2024**
(21) Application number: 22383304.7
(22) Date of filing: 28.12.2022
(51) Int. Cl.: G01R 19/00, H01H 85/02, H01H 85/30, G01R 15/18, G01R 15/14

(54) **DEVICE AND METHOD FOR MEASURING ELECTRIC PARAMETERS IN FUSE-HOLDER BASE INSTALLATIONS**

(71) Applicant: Gorlan Team, S.L.U., 48340 Amorebieta Vizcaya (ES)
(72) Inventor: Plasencia Alonso, Esther, Amorebieta, Vizcaya (ES); Fernández Duque, David, Amorebieta, Vizcaya (ES)
(74) Representative: Balder IP Law, S.L.

(57) **Abstract**

The invention refers to a measuring device (1) for fuse-holder base installations, the device comprising: a casing (3), an electronic module (4) couplable to the casing (3) or integrated in the casing (3) and attaching means (8,9) for attaching the casing (3) to an output conductor such as an output cable (6) of the installation. The attaching means are configured to be wrapped, around the insulating sleeve (7) of an output cable (6) or other part or an output conductor, so that there is no need to disconnect the cable for attaching the casing. The device comprises a current sensor (10a, 10b, 10c) and a first clamp for clamping the current sensor to the insulating sleeve (7) of an output cable (6), and a voltage sensor (11a, 11b, 11c) and a second clamp for clamping the voltage sensor around the insulating sleeve to an output cable.

## Description

### TECHNICAL FIELD

The present invention refers to a measuring device and a method for measuring electric parameters in a fuse-holder base installation, in particular for measuring electric parameters downstream the fuse-holder base, for example at the output conductors and/or at the output cables of the installation.

An object of the invention is to provision of a device and a method that allow obtaining electrical parameters in existing fuse-holder base installations, without disconnecting the output cables from the fuse-holder base and without interrupting the operation of the fuse-holder base installation.

### STATE OF THE ART

A fuse-holder base generally consists of a rail or socket that supports the connection contacts or clamps, and it is connected to the respective bus bars. These fuse-holder bases may include one or more fuse-holders, that can be disconnected for the fuse replacement when necessary. Fuse-holder bases including three pairs of contacts are known, wherein each pair of contacts is electrically connected to a conductive strip of the low-voltage switchboard of the corresponding electric installation. There is generally one pair of contacts for each electric phase, and a fuse is coupled between that pair of contacts.

The European patent application EP-3.252.795 A1 describes an example of a fuse-holder base.

Generally, fuse-holder bases are classified according to the number of poles or phases they protect. They can be single-pole when they protect one phase, two-pole for two phases, or, in the most common cases, three-pole when the three phases of the distribution system are protected.

It is known to provide a measurement module for the output conductors of a fuse-holder base, to obtain voltage and current measurements downstream the fuse-holder base. For this, some fuse-holder bases integrate voltage and currents sensors, but obviously this solution requires replacement of older models of fuse-holder bases and the interruption of the operation and power supply to carry out the replacement.

Other known solution for fuse-holder bases monitoring, is the one described in the Spanish Patent Application ES-2401834 A2 consisting of a sensor accessory connectable to the output terminals of the fuse-holder base, that integrates built-in current transformers and voltage taps for each phase, and the required electronics for processing the sensed signals. Again, the drawback of using this sensor accessory is that for their installation, the output cables have to be disconnected and the operation of the fuse-holder base interrupted.

Other drawback of this sensor accessory is that, as they have connection terminals in fixed positions, they are not a universal solution because they can only be used with the fuse-holder bases having connection terminals arranged in the same position as the accessory's terminals. Furthermore, these accessories are bulky and require a large space to be installed, which is not always available.

Other known solution relies on open core current sensors, such as Rogowsky coils or conventional Current Transformers, but these solutions do not incorporate voltage sensors downstream of the line fuse. Furthermore, the processing electronics are usually located in another area away from the Low Voltage Cabinet, so the wiring is complicated, as the six secondary wires of the three Current Transformers and the three voltage wires (in a case of a three-phase application) have to be routed to the electronics.

Therefore, there is a need in this technical field for a universal device of reduced size for measuring electric parameters downstream the fuse-holder base, that can be installed or retro-fitted in fuse-holder bases installations, without disconnecting the output cables and without cutting off the power supply.

### DESCRIPTION OF THE INVENTION

The invention is defined in the attached independent claims, and satisfactorily solves the above-described drawbacks of the prior art, by the provision of a measuring device as defined in the attached claim 1, and a measuring method as defined in claim 15.

More in detail, an aspect of the invention refers to a measuring device for fuse-holder base installations, wherein the installation comprises a fuse-holder base with at least one fuse-holder, and at least one output conductor connected downstream the fuse-holder. The output conductor is an output terminal or an output cable connected to the output terminal, wherein the output cable conventionally has a lead wire covered by an insulating sleeve. The fuse-holder base is meant to be connected to a bar of a bus bar distribution arrangement which is the input of the installation.

According to the invention, the device comprises a casing made of an electric insulating material, and an electronic module which is couplable to the casing. The electronic module has a housing which is mechanically couplable to the casing, and the electronics (A/D converters, processor, communications etc.) of the electronic module are enclosed in the housing.

Alternatively, the electronic module is integrated in the casing, which means that the electronics of the electronic module, are enclosed within the casing. In this case, the casing is also the housing of the electronic module, or in other words, the housing of the electronic module is also the casing, so that, the electronic module can be clamped to an output conductor or output cable by means of its own housing.

The device is provided with attaching means for attaching the casing to an output conductor of the installation, such as an output terminal or an output cable, so that the casing is sustained by the output conductor to which is attached. In a preferred embodiment, the output conductor is an output cable.

This attaching means are configured to be wrapped fully or partially around: an output terminal, a metallic part of an output cable, and/or the insulating sleeve of an output cable. In this way, there is no need to disconnect the output cable from the fuse-holder base to attach the casing with the electronic module, or to cut-off power supply through the fuse-holder base.

In a preferred embodiment, the attaching means are configured to be wrapped, at least partially, around the insulating sleeve of an output cable, so that the attaching means are not in contact with the metallic conductor inside the insulating sleeve

The device further comprises at least one current sensor and a first clamp for clamping the current sensor to an output conductor of the installation, preferably around (fully or partially) a part of the insulation sleeve of an output cable of the installation, so that the current sensor can measure currents flowing through the cable to which is clamped.

Additionally, the device comprises at least one voltage sensor couplable to an output cable for measuring voltage on the output cable. Preferably, the device comprises a second clamp for clamping the voltage sensor around (fully or partially) a part of the insulation sleeve of an output cable, so that the voltage sensor can measure voltage at that output cable to which is clamped.

Due to the provision of the attaching means and first and second clamps configured to be wrapped (fully or partially) around a part of the insulation sleeve of an output cable, there is no need to disconnect the output cable from the fuse-holder base or to cut-off power supply through the fuse-holder base, to clamp the casing with the electronic module and the voltage and current sensors to the output cables.

Additionally, the measuring device includes a first set of wires for connecting the current sensor with the electronic module, and a wire for connecting the voltage sensor to the electronic module, or a second set of wires in case that there is more than one voltage sensor, for connecting the voltage sensors to the electronic module.

The electronic module includes an A/D (analog to digital) converter adapted for converting analog signals received from the current and voltage sensors into digital signals, and optionally communication means for transmitting these digital signals to a remote location. The electronic module may also include processing means to determine the status of the fuses or other monitoring functions.

The casing has a rear face, a front face and four lateral sides facing each other in pairs, and the casing is fitted with connectors for connecting the first set, the wire or wires of the second set of wires. Preferably, these connectors are provided at the front face of the casing, and/or one of the lateral sides so that the connectors are accessible through the front face and/or one of the lateral sides, for connecting the wires of the first and second sets.

The attaching means are provided at the rear face of the casing, and/or in one or two lateral sides of the casing.

The electronic module is enclosed in a housing which is couplable to the front face of the casing. The casing has internal electric conductors electrically connecting the electronic module with the connectors when the housing is coupled with the casing, so that the electronic module can receive signals from the current and voltage sensors. In this way, the electronic module can be easily replaced if necessary or disconnected for inspection, without the need to disconnect other components of the measuring device.

In a preferred embodiment, the current sensor is a split core current sensor enclosed inside a current sensor housing, and the first clamp is formed by the current sensor housing. This housing conventionally has two parts coupled at an articulation, so that one part can pivot with respect to the other part for opening and closing the split core current sensor. Therefore, this housing has two positions, namely: an open position when the two parts are disengaged so that the split core current sensor can be coupled or uncoupled from a cable, and a closed position when the two parts are engaged together. In the closed position, the housing is configured to be clamped to the insulating sleeve of a cable.

In a preferred embodiment, the voltage sensor includes a piercing member having a metallic tip. The piercing member is configured for piercing the insulating sleeve of an output cable, and it is displaceable (for example threaded) with respect to the second clamp, so that the metallic tip can get in contact with the metallic conductor of the cable, by displacing for example by rotating the piercing member upon perforating the insulating sleeve.

In a preferred embodiment of the invention, the attaching means for attaching the casing to the insulating sleeve of an output cable of the installation, are the first clamp or the second clamp or both are used as the attaching means. For this, the first clamp or the second clamp or both, can be attached to the casing, so that the casing is supported on an output cable by means of the first clamp or the second clamp or both.

In a preferred embodiment of the invention, the second clamp and the first clamp are configured to be detachable coupled to each other, so that the current sensor and the voltage sensor can be clamped to the same output cable for measuring current and voltage respectively in the same output cable, while they are coupled to each other, either in an upstream or downstream relative arrangement between them.

In another preferred embodiment of the invention, the voltage sensor and the current sensor are configured to be attached together in an upstream or downstream relative arrangement between them, so that, when it comes to installing the device of the invention to an installation, the technician has the liberty to decide what arrangement is more convenient depending on the available space of each particular installation. The coupling between the voltage and current sensors, can be realized by any conventional means, such as cooperating rails and guides, or by means of a dovetail means.

Alternatively, the current sensor and voltage sensor can be installed separated from each other, depending on the available space of each particular installation.

Furthermore, the attaching means for attaching the casing to an output cable of the installation is the assembly composed of the second clamp and the current sensor housing attached together. The current sensor housing or the second clamp is attached to the casing, so that the casing is supported on an output cable by means of the current sensor housing or by means of the second clamp.

Preferably, the casing has a receptacle at its front face and the electronic module housing is received at least in part within the receptacle.

The first clamp, the second clamp, or the set composed of the second clamp and the current sensor housing attached together, is joined to one of the lateral sides of the casing.

Another aspect of the invention refers to a fuse-holder base installation comprising a fuse-holder base including at least one fuse-holder connected to a bar of a bus bar distribution arrangement, and at least one output conductor such as an output terminal or output cable electrically connected to the fuse holder, wherein the installation incorporates a measuring device as the one defined above. In this installation, the casing is attached to an output conductor, preferably attached to a part of the insulating sleeve of an output cable, and the current and voltage sensors are clamped to the insulating sleeve of an output cable respectively for measuring current and voltage at the output cable to which they are clamped.

The casing, the voltage sensor, and the current sensor may be clamped individually to different parts of the output cable, which are more easily accessible to a technician carrying out the installation of the device.

In a preferred embodiment, the installation is a three-phase installation comprising: three fuse-holders each one connected to a bar a bus bar system, and three output cables each one connected to a fuse-holder, one casing and one electronic module, three current sensors and three voltage sensors, each current or voltage sensor clamped and connected to one output cable, and wires connecting the three current sensors and three voltage sensors to the electronic module, so that current and voltage in each one of the three output cables (in each phase of the installation) can be measured.

One of the advantages of the invention is that the number of wires to be used is significantly reduced, as the electronic module is located in the vicinity of voltage and current sensors, the wires connecting the secondary winding of the current sensor and the wire of the voltage tap are directly connected the A/D converter of the electronic module.

For example, in the case of a three-pole installation with three voltage sensors and three current sensors for measuring voltage and current in each one of the three lines, using prior art solutions, 9 wires (6 for the current sensors and 3 for the voltage sensors) per fuse holder base, would have to be routed to a remote location from the fuse-holder base installation. However, with the present invention, these 9 cables are routed to the nearby electronic module, and only one cable per fuse holder base leaves from the electronic module, as opposed to the 9 cables of the state of the art.

Additionally, that the length of these wires could possibly be reduced, which is very convenient because usually the available space inside electric cabinets where fuse-holder bases are commonly enclosed, is very scarce.

Moreover, since the casing and current and voltage sensors or at least some of them can be clamped individually in any available part of an output conductor or output cable, this liberty of coupling the casing and sensors to output conductors or cables, renders the device to be universal as it can be easily installed in any existing installation even if the output cables are hardly accessible.

Yet, another aspect of the invention is a method for measuring electric parameters at a fuse-holder base installation, wherein the installation comprises a fuse-holder base with at least one fuse-holder, and at least one output conductor, such as an output cable, connected to the fuse-holder. The fuse-holder base is meant to be connected to a bar of a bus bar distribution system, which is the input of the installation.

The method comprises the following steps, performed not-necessarily in a particular sequential order:
providing a casing made of an electric insulating material, and an electronic module coupled to the casing or integrated in the casing, and
attaching the casing to: an output conductor, to a metallic conductor of an output cable or to the insulating sleeve of an output cable of the installation, while the output cable remains connected to a fuse-holder of the base, that is allowing current to circulate through the fuse-holder and through the output cable. In this way, the casing is sustained by the output conductor or by the output cable to which is attached. Preferably, the attaching means are configured to be wrapped around fully or partially around a part of the insulating sleeve of an output cable.

The method further comprises the step of providing at least one split core current sensor, and the step of clamping the current sensor to the insulating sleeve of an output cable while the output cable remains connected to a fuse-holder of the base, thus, allowing current to circulate through the fuse-holder and through the output cable.

The method further comprises the step of providing at least one voltage sensor comprising a clamp and a piercing member having a metallic tip, and clamping the voltage sensor to the insulating sleeve of an output cable while the output cable remains connected to a fuse-holder of the base, again allowing current to circulate through the fuse-holder and through the output cable.

The insulating sleeve of the output cable is then perforated with the piercing member, in a way that the metallic tip gets in contact with the electric conductor of the output cable, in order to take voltage measurements at that output cable with respect to ground of the installation (it is implicit that the voltage sensor is properly connected to obtain voltage measurements between two points of the installation).

Additionally, the method comprises the step of electrically connecting the current sensor and the voltage sensor to the electric module by means of wires passing through the casing, and processing with the electronic module the analogue signals supplied by the current and voltage sensors.

The electronic module includes an A/D converter adapted for converting analog signals received from the current and voltage sensors into digital signals, processing means and optionally communication means for transmitting the digital signals.

In a preferred embodiment, the step of attaching the casing to: an output conductor, to a metallic conductor of an output cable or to the insulating sleeve of an output cable of the installation, is carried out using the voltage sensor, the current sensor or both, so that the casing is supported by the voltage sensor, the current sensor or by both.

### BRIEF DESCRIPTION OF THE DRAWINGS

To complete the description and in order to provide a better understanding of the invention, a set of drawings is provided. These drawings form an integral part of the description and illustrate embodiments of the invention, which should not be interpreted as restricting the scope of the invention, but just as examples of how the invention can be carried out. The drawings comprise the following figures:
Figure 1.- shows in drawing A and B two perspective views of the measuring device of the invention operatively installed in a fuse-holder base installation. In drawing B the connection wires are not shown for the sake of simplicity and clarity of the illustration.
Figure 2.- shows in drawings A, B and C, three different perspective views of the casing clamped to an output cable.
Figure 3.- shows in drawings A, B and C, three different perspective views of a current and voltage sensors and respective clamps, coupled together.
Figure 4.- is a perspective view of the component of figure 3 clamped and connected to an output cable.
Figure 5.- shows two perspective views of a casing alone (drawing A), and with the electronic module coupled to it (drawing B).
Figure 6.- shows two perspective views of a casing clamped to an output cable, and with the electronic module coupled to the casing.
Figure 7.- shows two perspective views of a casing having the component of figure 3 attached to it.

### PREFERRED EMBODIMENTS OF THE INVENTION

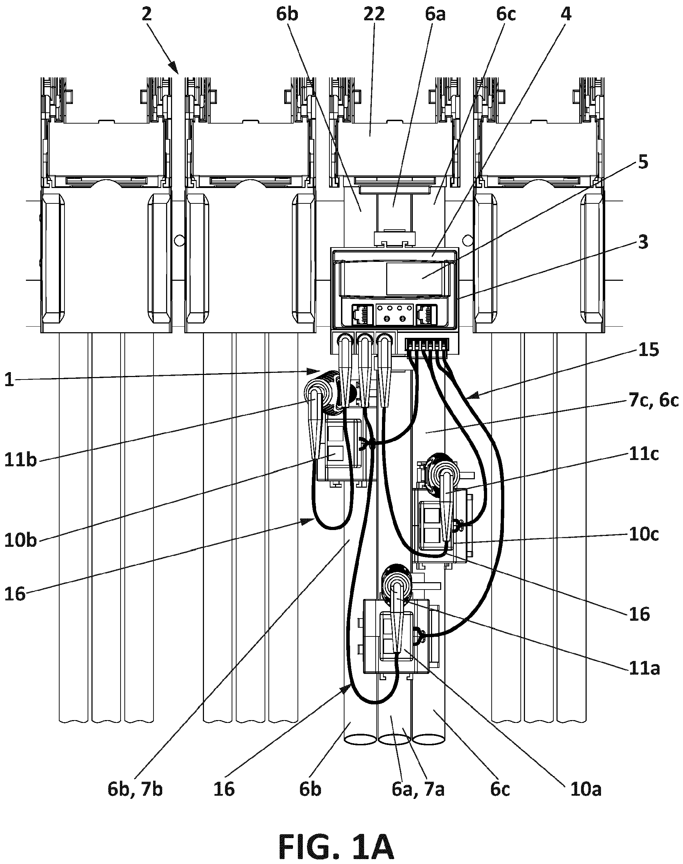

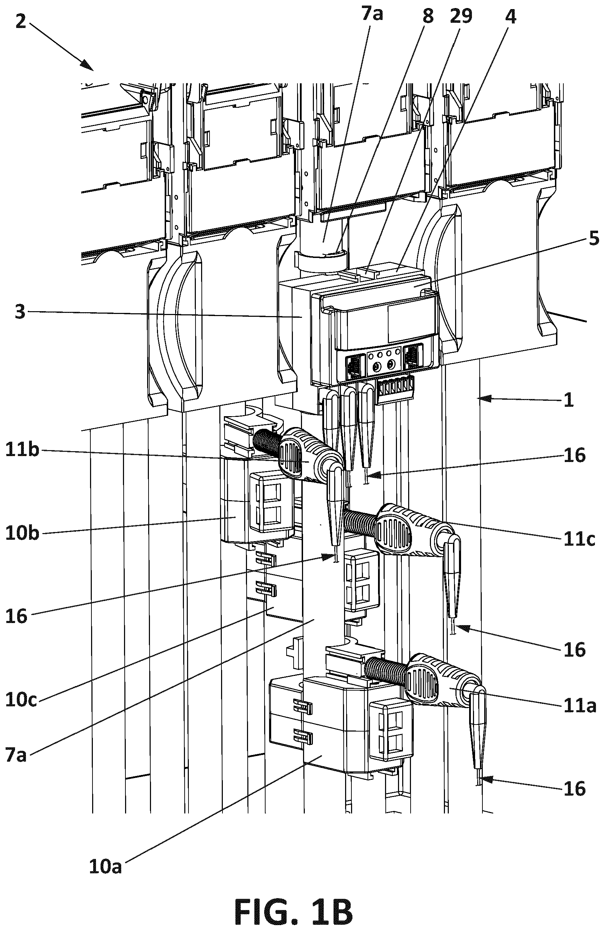

**Figures 1A****,** **1B** show two perspective views of a measuring device (1) of the invention operatively installed in a fuse-holder base installation (2), in this example a three-phase installation. The installation comprises: at least one fuse-holder base (22) including three fuse-holders each one connected to a bar of a bus bar system (not shown), and three output cables (6a,6b,6c) each one connected to a fuse-holder.

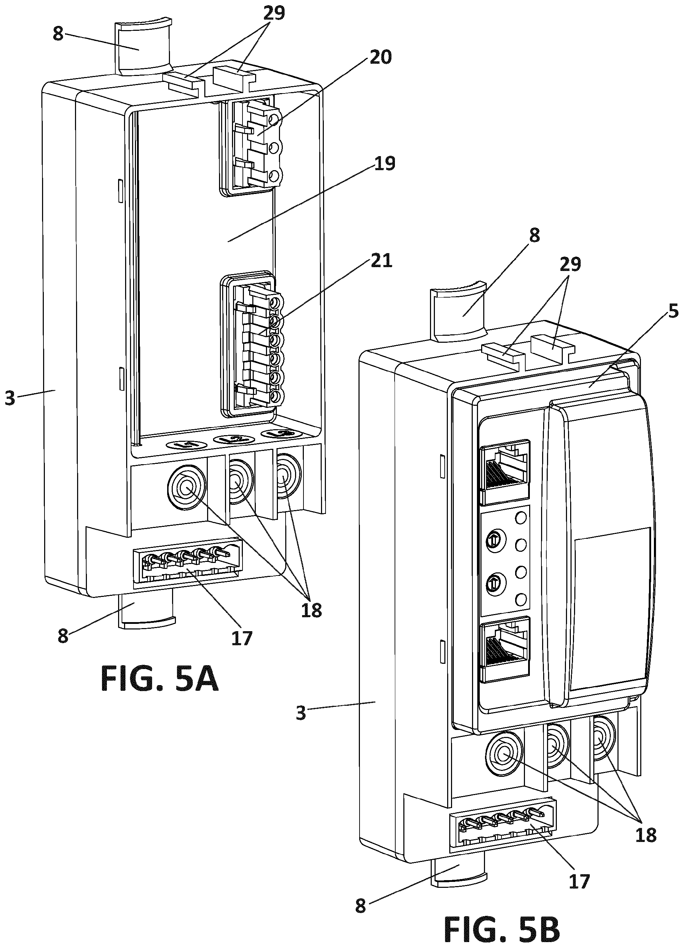

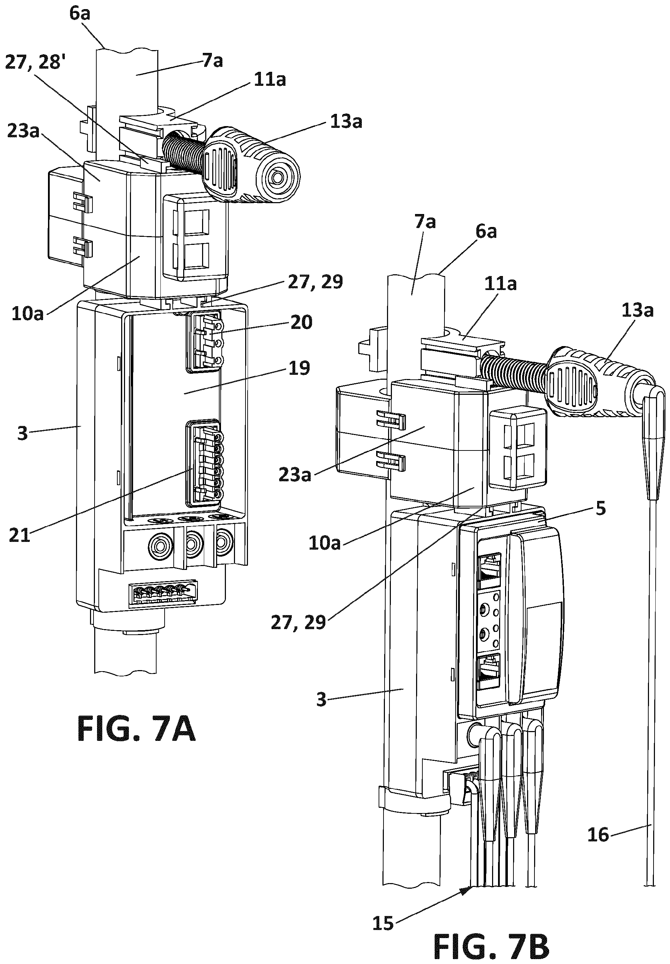

The measuring device comprises a casing (3) made of an insulating material, and a housing (5) of an electronic module (4) coupled at the front face of the casing (3). More in detail, the casing (3) has a receptacle (19), shown in **Figures 5A** and **7A****,** at its front face, and the housing (5) of electronic module (4) is received at least in part within that receptacle (19).

The casing (3) is attached to a part of the insulating sleeve (7a) of a first output cable (6a) of the installation (2), by means of attaching means, that in this case are embodied as two curved walls (8) formed at the rear face of the casing (3) and respective flexible clamps (9) wrapped partially around the sleeve (7a) pressing the walls (8) against the sleeve (7a).

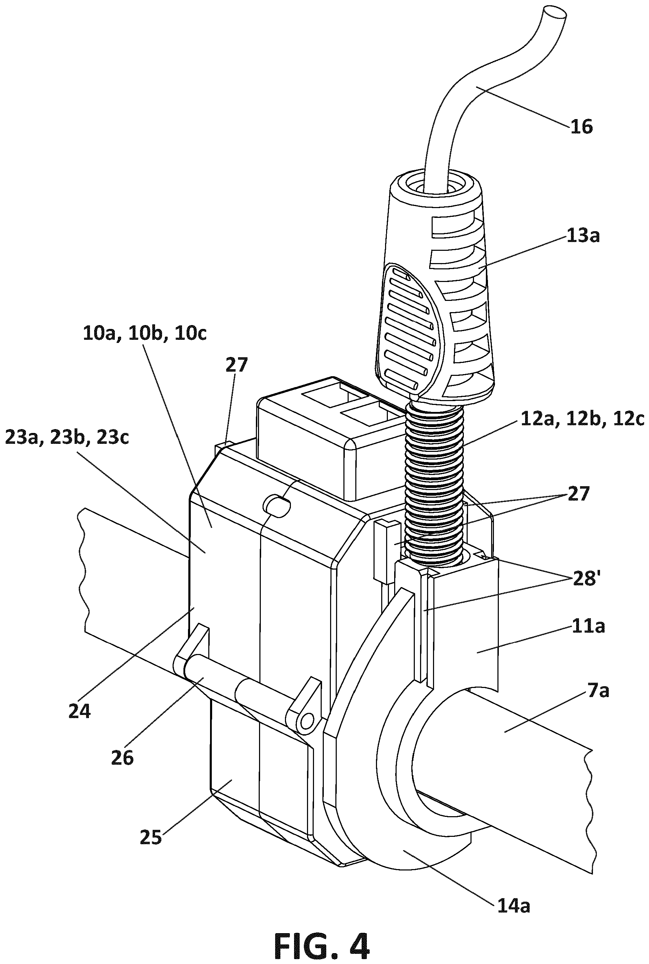

The device (1) includes three split-core current sensors (10a,10b,10c), each one enclosed inside a current sensor housing (23a,23b,23c), so that this housing configure a first clamp formed by the current sensor housing, which can be clamped around an insulating sleeve (7a,7b,7c) as better shown in **Figure 4****,** so that each current sensor is attached to the respective insulating sleeve (7a,7b,7c) and it can measure currents flowing through the cable to which is clamped.

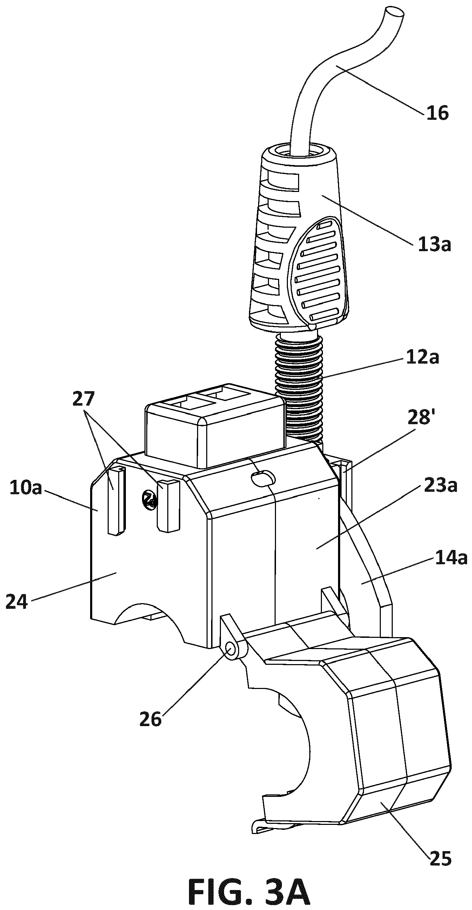

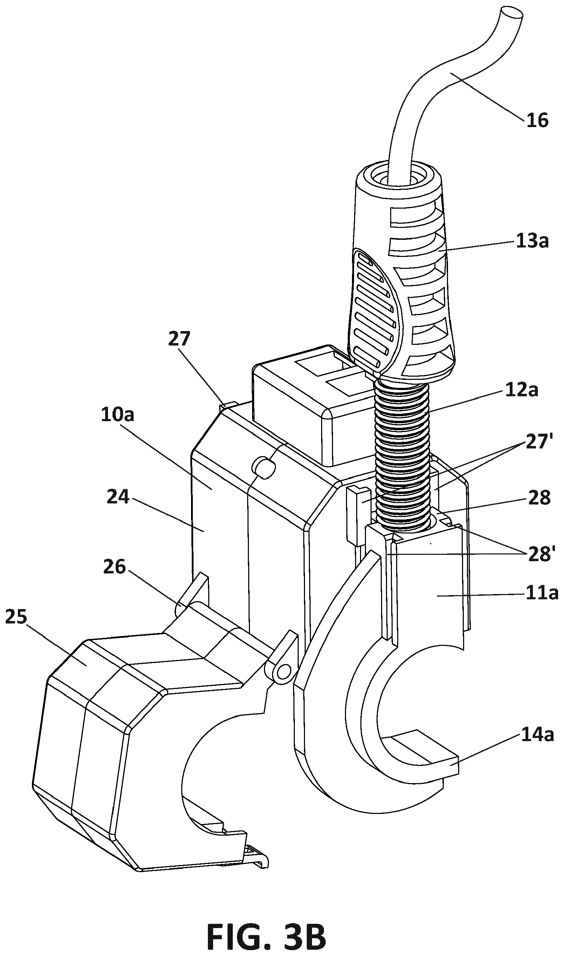

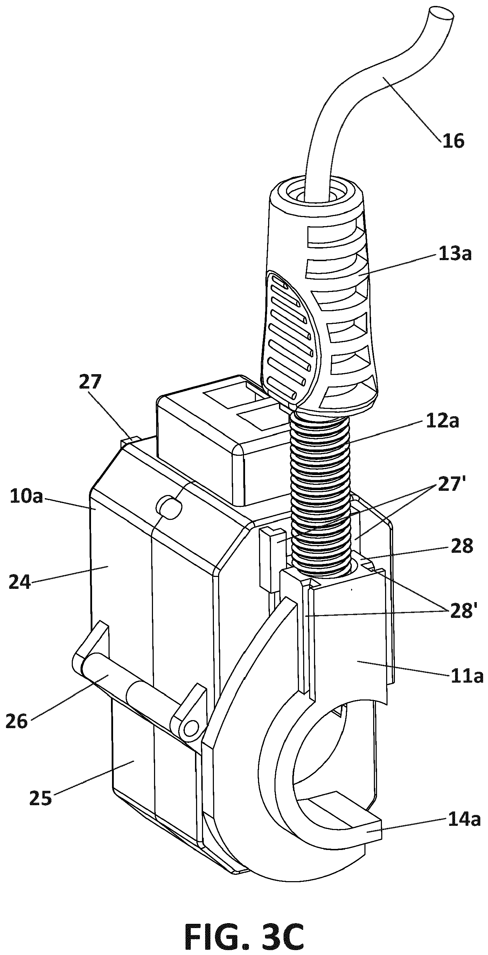

This current sensor housing (23a) conventionally has two parts (24,25) coupled at an articulation joint (26), so that one part can pivot with respect to the other for opening and closing the split core current sensor. Therefore, this housing has two positions, namely: an open position as the one shown in **Figures 3A****,** **3B** when the two parts (24,25) are disengaged so that the split core current sensor can be coupled or uncoupled from a cable, and a closed position as the one shown in **Figures 3C****,** **4** when the two parts (24,25) are engaged together. As shown, in the closed position, the housing is configured to be clamped to the insulating sleeve (7a) of a cable (6a).

Additionally, the device (1) includes three voltage sensors (11a,11b,11c) configured as a second clamp for clamping the voltage sensor, at least in part, around the insulating sleeve (7a,7b,7c) of an output cable, and in a way that the voltage sensor can measure voltage at that output cable (6a,6b,6c) to which is clamped.

A voltage sensor (11a,11b,11c) is represented in more detail **in** **Figures 3A** to **3D,** and includes a clamp (14a) and piercing member (12a) having a metallic tip (not shown) at a free end and a handled (13a) at the other end. The piercing member (12a) is configured for piercing the insulating sleeve (7a) of an output cable (6a), and for that purpose, the piercing member is threaded in the clamp (14a) so that the metallic tip can get in contact with the metallic conductor by rotating the piercing member.

The electronic module (4) includes an A/D converter (not shown) adapted for converting analog signals received from the current and voltage sensors into digital signals, and optionally communication means for transmitting the digital signals.

As shown in **Figures 1A** and **1B****,** a first set of wires (15) is provided connecting the split-core current sensors (10a, 10b, 10c) to the electronic module (4) (a pair of wires for each current sensor), and a second set of wires (16) is provided connecting the voltage sensors (11a,11b,11c) to the electronic module (4) (one wire for each voltage sensor, so that each voltage sensor can measure voltage with respect to ground).

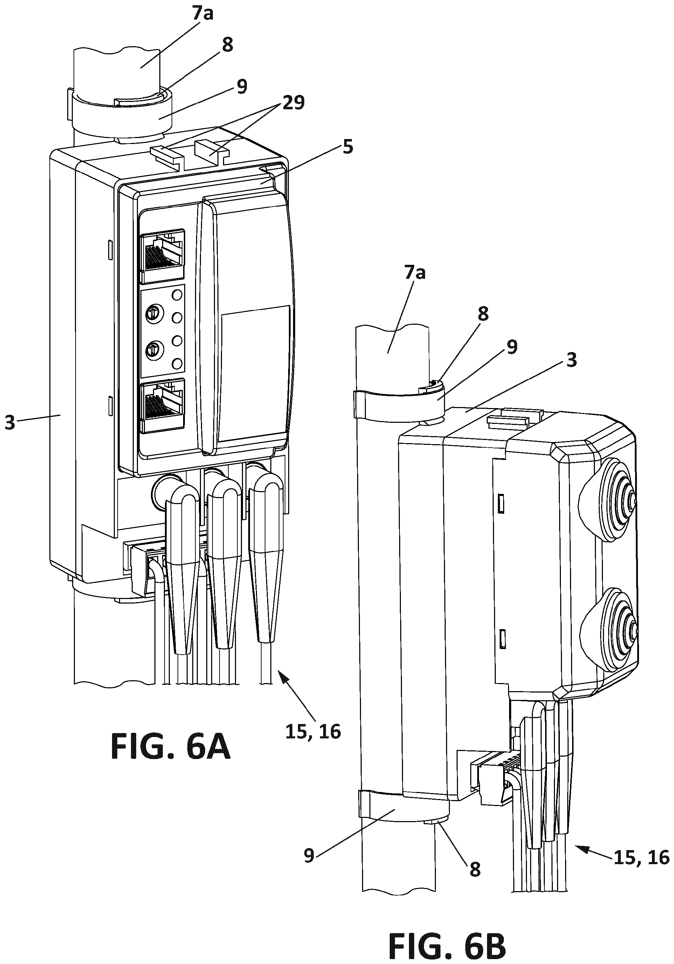

For connecting the first and second set of wires (15,16), the casing (3) has connectors (17,18) accessible through the front face of the casing (3) as shown in **Figures 5****,** **6** and **7****,** for connecting these wires of the first and second sets (15,16).

As shown for example in **Figures 5A****,** **7A****,** the casing (3) has internal electric connectors (20,21) located inside the receptacle (19), which are electrically connected respectively with the connectors (17,18) by means of internal conductors (not shown) enclosed inside the casing (3). In turn, the housing (5) of the electronic module (4) has connectors (not shown) at its rear face that connect with the internal connectors (20,21), so that the electronic module (4) can receive measurements from the current and voltage sensors in the form of analog signals.

In the embodiment shown in **Figures 3** and **4****,** the current sensor (10a) and the voltage sensor (11a) are joined together forming a single assembly or component capable of measuring current and voltage from the same output cable. It is to be understood that even if **Figures 3** and **4** show only one of these components, the measuring device (1) would incorporate one of these assemblies or components for each phase to be monitored.

The voltage sensor and the current sensors (10a-10c, 11a- 11c) are configured to be attached together in an upstream or downstream relative arrangement between them, as shown in **Figures 3** and **4****.** The coupling between the voltage and current sensors, can be realized by any conventional means, for example in the embodiment shown in **Figures 3** and **4****,** the current sensor housing (23a) has two pairs of guides (27,27') provided at opposite sides of the housing (23a), and the voltage sensor (11a) has two pairs of rails (28,28') cooperating with any of the guides (27,27'), in a way that rails (28,28') can slide inside in any one of the guides (27,27') for the attachment in any relative position of the voltage sensor and the current sensors (10a-10c, 11a- 11c).

Alternatively, the current sensor and voltage sensor shown in **Figures 3A-C** and **4****,** can be installed separated from each other, depending on the available space of each particular installation.

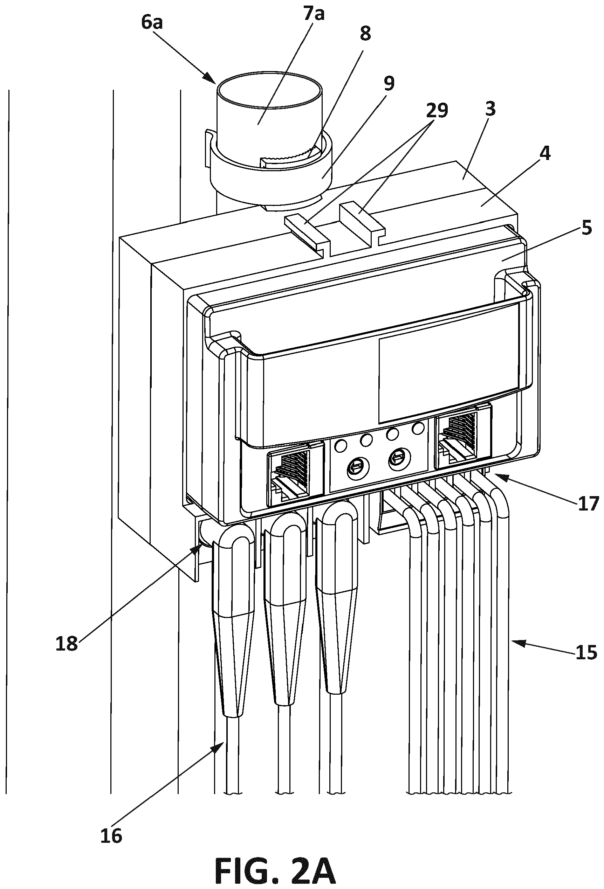

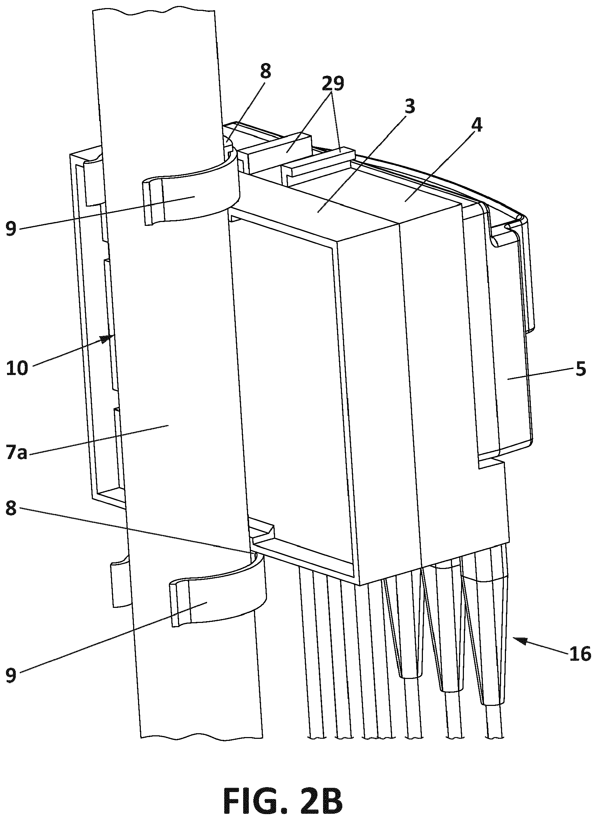

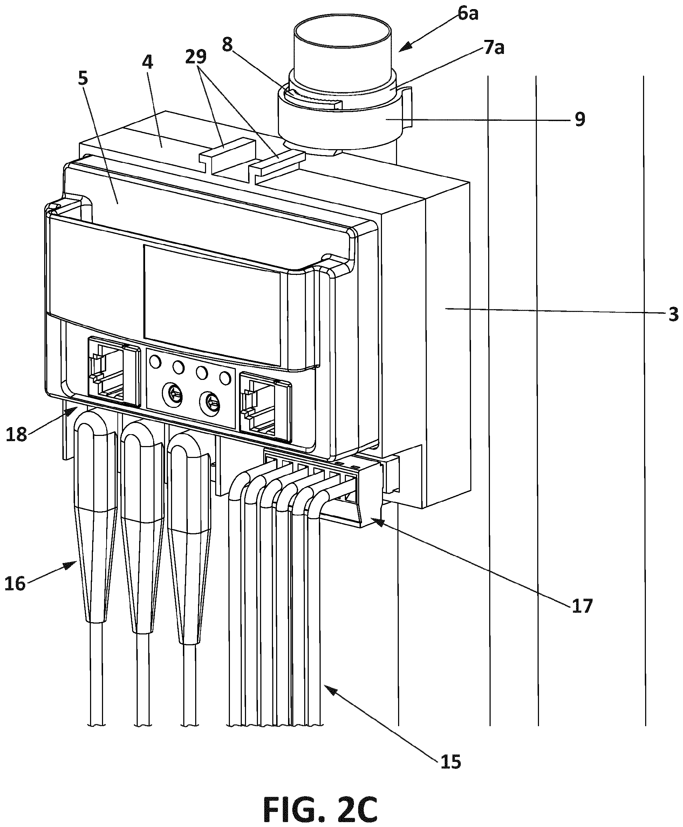

In a preferred embodiment of the invention, in addition or instead of the attaching means shown in **Figures 1** and **2****,** for attaching the casing (3) to an insulating sleeve (7) of an output cable (6) of the installation, the clamp of the current sensor or the clamp of the voltage sensor, is used to attach the casing (3) to a cable (6), in which case, either the housing of the current sensor or the clamp of the voltage sensor is joined to the casing (3), so that the casing (3) is supported by an output cable (3) by means of the current sensor or by the voltage sensor.

In preferred embodiment shown in **Figures 7A, 7B****,** the attaching means for attaching the casing (3) to an output cable (6), is also the assembly composed of the second clamp and the current sensor housing attached together as shown in **Figures 3A-3C** and **4.** The current sensor housing (23a) or the second clamp is joined to the casing (3), so that the casing is supported by an output cable by means of the current sensor housing or the second clamp. In particular, in the embodiment shown in **Figures 7A, 7B****,** the housing (23a) of the current sensor (10a) is joined to the upper lateral side of the casing (3), and the voltage sensor (11a) is attached to the current sensor (10a). The current sensor (10a) is arranged downstream the voltage sensor (11a). For this purpose, the casing (3) is provided with at least in one of its lateral sides, with a pair of guides (29), and the guides (27,27') or the rails (28,28') can be engaged with the guides (29).

Both, the current sensor (10a) and the voltage sensor (11a) are clamped to the insulating sleeve (7a) of the same cable (6a), so that the casing (3) is supported by the cable (6a) by means of the current sensor (10a) and the voltage sensor (11a).

The method of the invention for measuring electric parameters at a fuse-holder base installation, is also illustrated in **Figures 1A****,** **1B****.** The casing (3) is clamped to the insulating sleeve (7a,7b,7c) of one of the three output cables (6a,6b,6c) of the installation (2), preferably to the one which is furthest ahead, and to a part of the same which is more easily accessible and provides room to accommodate the casing. This step is carried out while the output cable (6a,6b,6c) remains connected to a fuse-holder of the base (22).

Current sensors (10a,10b,10c) and the voltage sensors (11a,11b,11c) are also provided and clamped individually to the three output cables (6a,6b,6c) of the installation, and to the parts of those cables that are more easily accessible, and which are closer to the casing. This step is carried out also while the output cable remains connected to a fuse-holder of the base.

The electronic module (4) is also provided and connected to the casing (3), and the current sensors (10a,10b,10c) and the voltage sensors (11a,11b,11c) are connected to the electric module by means of wires (15,16) passing through the casing (3).

Therefore, the measuring device (1) can be installed without disconnecting the output cables from a fuse-holder base and without cutting off power supply.

In a preferred embodiment, the step of attaching the casing to the insulating sleeve of an output cable of the installation, is carried out using the voltage sensor, the current sensor or both, so that the casing is supported by the voltage sensor, the current sensor or by both.

## Claims

1. Measuring device (1) for fuse-holder base installations, the measuring device (1) comprising:
a casing (3) made of an insulating material,
an electronic module (4) couplable to the casing (3) or integrated in the casing (3),
attaching means (8,9) for attaching the casing (3) to an output conductor (6a,6b,6c) of the installation, wherein the attaching means (8,9) are configured to be wrapped, at least in part, around the output conductor (6),
at least one current sensor (10a,10b,10c) and a first clamp for clamping the current sensor, at least in part, to an output conductor (6a,6b,6c) of the installation, and in a way that the current sensor can measure currents flowing through the output conductor (6a,6b,6c) to which is clamped,
at least one voltage sensor (11a,11b,11c) couplable to an output conductor (6a,6b,6c) for measuring voltage at the output conductor,
so that the casing (3), and the current and voltage sensors (10a,10b,10c, 11a,11b,11c) can be operatively clamped to output conductors (6a,6b,6c) without disconnecting the output conductors from the fuse-holder base installation,
the device (1) further comprising:
a first set of wires (15) connecting the current sensor (10a,10b,10c) to the electronic module (4),
at least one wire (16) connecting the voltage sensor (11a,11b,11c) to the electronic module (4), and
wherein the electronic module (4) includes an A/D converter adapted for converting analog signals received from the current and voltage sensors into digital signals.

2. Measuring device according to claim 1, comprising a second clamp for clamping the voltage sensor, at least in part, around the insulating sleeve of an output conductor, and in a way that the voltage sensor can measure voltage on the output conductor to which is clamped.

3. Measuring device according to claim 1 or 2, wherein the casing (3) has connectors (17,18) for connecting the first and second set of wires (15,16), and wherein the casing (3) has a rear face and a front face, and lateral sides, and wherein the attaching means (8,9) are provided at the rear face and/or at a lateral side of the casing (3), and the connectors (17,18) are accessible through the front face or through one of the lateral sides of the casing for connecting the wires of the first and second sets (15,16).

4. Measuring device according to any of the preceding claims, wherein the electronic module (4) is enclosed in a housing (5), and wherein the housing (5) is couplable to the front face of the casing (3), and wherein the casing (3) has internal electric conductors electrically connecting the electronic module (4) with the connectors (17,18) when the housing (5) is coupled with the casing (3).

5. Measuring device according to any of the preceding claims, wherein the current sensor (10a,10b,10c) is a split core current sensor enclosed inside a current sensor housing (23a,23b,23c), and wherein the first clamp is formed by the current sensor housing.

6. Measuring device according to any of the preceding claims, wherein the output conductor (6a,6b,6c) is an output cable having a metallic conductor covered by an insulating sleeve (7a,7b,7c), and wherein the voltage sensor (11a,11b,11c) includes a piercing member (12a) having a metallic tip and it is configured for piercing the insulating sleeve (7a) of an output cable, so that the metallic tip can get in contact with the metallic conductor of the output cable.

7. Measuring device according to any of the preceding claims, wherein the attaching means (8,9) for attaching the casing (3) to an output conductor of the installation, are the first clamp of the current sensor (10a,10b,10c) which is attached to the casing (3), so that the casing (3) can be supported on an output conductor by means of the first clamp.

8. Measuring device according to any of claims 2 to 6, wherein the attaching means (8,9) for attaching the casing (3) to an output conductor of the installation, is the second clamp which is attached to the casing (3), so that the casing (3) can be supported on an output conductor by means of the second clamp.

9. Measuring device according to any of the claims 2 to 8, wherein the second clamp and the first clamp are configured to be detachable coupled to each other.

10. Measuring device according to claim 9, wherein the attaching means (8,9) for attaching the casing to an output conductor of the installation is the assembly composed of the second clamp and the current sensor housing attached together, wherein the current sensor housing or the second clamp is attached to the casing, so that the casing (3) is supported on an output conductor by means of the current sensor housing or the second clamp.

11. Measuring device according to claim 10, wherein the casing (3) has four lateral sides facing each other in pairs, and wherein the first clamp, the second clamp, of the assembly composed of the second clamp and the current sensor housing coupled together, is attached to one of the lateral sides of the casing.

12. Measuring device according to any of the preceding claims, wherein the output conductor (6a,6b,6c) is an output cable having a metallic conductor covered by an insulating sleeve (7a,7b,7c), and wherein the attaching means (8,9) and the first clamp are configured to be wrapped around, at least in part, the insulating sleeve (7a,7b,7c) of the output cable.

13. A fuse-holder base installation comprising a fuse-holder base including at least one fuse holder connected to a distribution bar and at least one output conductor electrically connected to the fuse holder, the installation incorporating a measuring device (1) as the one defined in any of the previous claims, and wherein the casing (3) is attached to the insulating sleeve (7a) of the output conductor (6), and the current and voltage sensors are clamped to the insulating sleeve of output conductor respectively for measuring current and voltage at the output conductor.

14. A fuse-holder base installation according to claim 13, wherein the installation is a three-phase installation comprising: three fuse-holders each one connected to a bar a bus bar system, and three output conductors each one connected to a fuse-holder, one casing and one electronic module, three current sensors and three voltage sensors, each current or voltage sensor clamped and connected to one output conductor, and wires connecting the three current sensors and three voltage sensors to the electronic module, so that current and voltage in each one of the three output conductors can be measured.

15. Method for measuring electric parameters at a fuse-holder base installation, comprising the following steps:
providing a casing made of an electric insulating material, and an electronic module coupled to the casing or integrated in the casing,
attaching the casing to an output conductor of the installation while the output conductor remains connected to a fuse-holder of the base, preferably attaching the casing to the insulating sleeve of an output conductor,
providing at least one split core current sensor and clamping the current sensor to the insulating sleeve of an output conductor while the output conductor remains connected to a fuse-holder of the base,
providing at least one voltage sensor comprising a clamp and a piercing member having a metallic tip, and clamping the voltage sensor to the insulating sleeve of an output conductor while the output conductor remains connected to a fuse-holder of the base,
perforating the insulating sleeve of an output conductor with the piercing member in a way the metallic tip contact with the electric conductor of the output conductor, and
electrically connecting the current sensor and the voltage sensor with the electric module by means of wires passing through the casing.
